# EUROPEAN PATENT APPLICATION

(11) **EP 2 819 160 A1**
(43) Date of publication of application: **31.12.2014**
(21) Application number: 14173336.0
(22) Date of filing: 20.06.2014
(51) Int. Cl.: H01L 23/48

(54) **Die-to-die inductive communication devices and methods**

(30) Priority: 28.06.2013 US 201313930250
(71) Applicant: Freescale Semiconductor, Inc., Austin, TX 78735 (US)
(72) Inventor: Pigott, John, Phoenix, AZ 85048 (US); Brauchler, Fred T, Michigan 48187, MI (US); Frear, Darrel R., Phoenix, AZ 85048 (US); Gupta, Vivek, Phoenix, AZ 85045 (US); Gray, Randall, Tempe, AZ 85283 (US); Owens, Norman Lee, Sun Lakes, AZ 85248 (US); D'Acosta, Carl Emil, Mesa, AZ 85204 (US)
(74) Representative: Optimus Patents Ltd

(57) **Abstract**

Embodiments of inductive communication devices (130, 200, 300, 600, 700, 800, 900, 1000, 1100) include first and second galvanically isolated IC die (140, 210, 310, 400, 610, 710, 810, 910, 1010, 1110, 150, 230, 330, 500, 630, 730, 830, 930, 1030, 1130). The first IC die has a first coil (144, 212, 312, 440, 612, 712, 812, 912, 1012, 1112) proximate to a first surface (208, 308, 404) of the first IC die, and the second IC die has a second coil (154, 232, 332, 540, 632, 732, 832, 932, 1032, 1132) proximate to a first surface (228, 328, 508) of the second IC die. The first and second IC die are arranged so that the first surfaces of the first and second IC die face each other, and the first coil and the second coil are aligned across a gap (170) between the first and second IC die. One or more dielectric components (160, 240, 340, 640, 740, 840, 940, 1040, 1140) are positioned within the gap directly between the first and second coils. During operation, a first signal is provided to the first coil, and the first coil converts the signal into a time-varying magnetic field. The magnetic field couples with the second coil, which produces a corresponding second signal.

## Description

### TECHNICAL FIELD

Embodiments relate generally to inductive communication circuits, systems, and methods.

### BACKGROUND

In a variety of applications, electrical (or galvanic) isolation is desired between distinct circuits while enabling communication between those circuits. "Galvanic isolation" means that there is no metallic or electrically conductive path between the distinct circuits. For example, galvanic isolation may be desired to protect a first circuit that operates at a relatively low supply voltage from a second circuit that operates at a relatively high supply voltage difference from the first circuit. In addition, galvanic isolation may be desired to isolate a first circuit tied to a first voltage reference (e.g., ground) from a second circuit tied to a different voltage reference (e.g., a floating voltage reference). Galvanic isolation also may be desired to prevent extraneous transient signals produced by one circuit from being conveyed to and processed by another circuit as valid signals or data.

A specific application that may benefit from galvanic isolation may be found within an automotive hybrid electric vehicle (HEV) system, for example. In an HEV system, a circuit that includes an insulated gate bipolar transistor (IGBT) array and corresponding gate drivers (referred to as an "IGBT circuit") may be used to rectify AC power, and to provide the resulting DC power to a high voltage battery (e.g., 300 volts (V) or more). A grounded control circuit (e.g., including a microcontroller) operating at a significantly lower vehicle chassis voltage (e.g., 12 V) may be used to provide control signals to the gate drivers. In order to isolate the control circuit from switching noise from the IGBT circuit, it may be desirable to provide complete galvanic isolation between the control circuit and the IGBT circuit.

In other systems, for safety reasons, it may be desirable to isolate equipment that is connected to an AC power line from conductive portions of the equipment that users can touch. In such systems, an isolation circuit may be used to mitigate the likelihood of shocks, burns, and/or electrocution from current flowing through a human body to ground.

Conventional techniques for providing electrical isolation include the use of optical isolators, capacitive isolators, transformer-based isolators, and so on. However, these techniques may be non-optimal or unsuitable for some applications, in that they may be expensive, require a large amount of space, consume significant power, and/or have some other characteristics that may reduce their desirability for a given application.

### BRIEF DESCRIPTION OF THE DRAWINGS

FIG. 1 is a simplified, circuit diagram illustrating a system that includes an inductive communication device that provides galvanic isolation between first and second circuits, according to an example embodiment;
FIG. 2 is a cross-sectional, side view of an inductive communication device, according to an example embodiment;
FIG. 3 is a cross-sectional, side view of an inductive communication device, according to another example embodiment;
FIG. 4 is a cross-sectional, side view of an integrated circuit die that may be used in an inductive communication device, according to an example embodiment;
FIG. 5 is a cross-sectional, side view of an integrated circuit die that may be used in an inductive communication device, according to another example embodiment;
FIG. 6 is a top view of a portion of an inductive communication device that includes a single communication path and a single primary/secondary coil pair, according to an example embodiment;
FIG. 7 is a top view of a portion of an inductive communication device that includes a single communication path and a single primary/secondary coil pair, according to another example embodiment;
FIG. 8 is a top view of a portion of an inductive communication device with two communications paths, each of which includes a single primary/secondary coil pair, according to an example embodiment;
FIG. 9 is a top view of a portion of an inductive communication device with two communications paths, each of which includes a single primary/secondary coil pair, according to another example embodiment;
FIG. 10 is a top view of a portion of an inductive communication device with a single communications path, which includes two primary/secondary coil pairs, according to an example embodiment;
FIG. 11 is a top view of a portion of an inductive communication device with a single communications path, which includes two primary/secondary coil pairs, according to another example embodiment; and
FIG. 12 is a flowchart of a method for manufacturing an inductive communication device, according to an example embodiment.

### DETAILED DESCRIPTION

As will be described in more detail below, embodiments described herein include inductive communication devices that may be incorporated into systems in which galvanic isolation between circuits is desired. As will be described in more detail later, embodiments of inductive communication devices include at least two IC die, each of which includes at least one conductive coil, arranged so that their respective corresponding coils are each aligned with each other across a gap. One or more dielectric components (including a physical dielectric structure) may be positioned within the gap, where the dielectric component(s) have properties that provide a desired level of galvanic isolation between the coils. In order to provide conductive connections between the conductive coil of the top IC die and the bond pads on its top surface, the top IC die may include conductive through-silicon vias, in an embodiment. Although the term "through silicon via" is used herein, it is to be understood that embodiments may include semiconductor substrates that are formed from materials other than silicon (e.g., gallium arsenide, gallium nitride, germanium, and so on). Accordingly, the term "through silicon via" should be interpreted to include vias that extend through semiconductor substrates other than silicon substrates. According to an embodiment, the IC die also may include communication circuitry (e.g., transmitter, receiver, and/or transceiver circuitry) coupled to the coils, where the communication circuitry converts input signals from communication signals that are conductive into inductive communication signals, and after the communication signals have been inductively communicated, converts the communication signals into an approximation of the input signals. According to an embodiment, the first and second IC die and the intervening dielectric component(s) all are packaged within a single integrated circuit package.

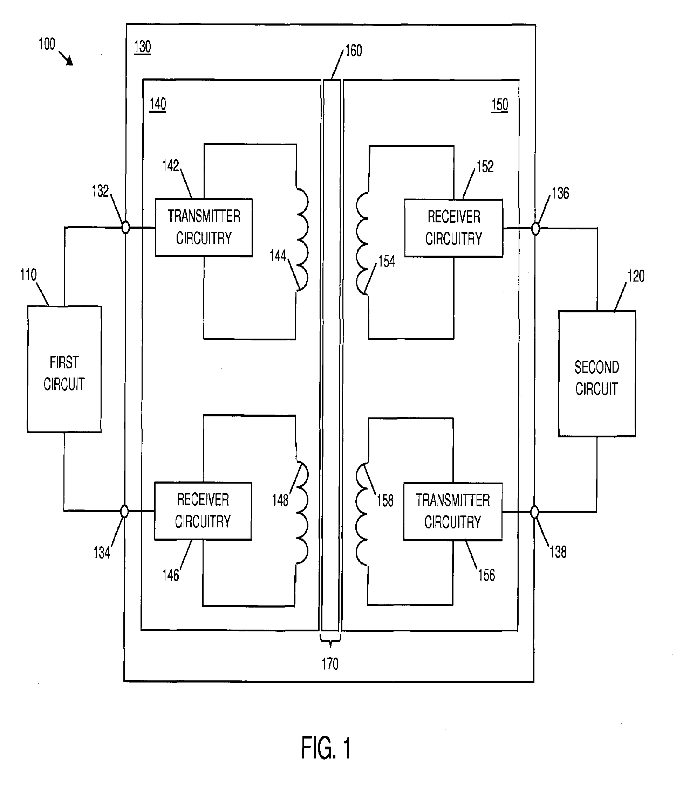

FIG. 1 is a simplified, circuit diagram illustrating a system 100 that includes an inductive communication device 130 that provides galvanic isolation between first and second circuits 110, 120, according to an example embodiment. Accordingly, inductive communication device 130 alternatively may be referred to as a "galvanic isolation device." In system 100, the first circuit 110 may operate at a relatively low supply voltage, and the second circuit 120 may operate at a voltage difference from circuit 110, although circuits 110, 120 may operate without a voltage difference, as well. In addition or alternatively, the first circuit 110 may be tied to a first voltage reference point (e.g., ground) and the second circuit 120 may be tied to a different voltage reference point (e.g., a floating voltage level), although circuits 110, 120 may be tied to the same voltage reference point, as well. System 100 may, for example, form a portion of a battery charging system for an HEV (e.g., the first circuit 110 may include a control circuit, and the second circuit 120 may include an array of IGBTs and associated gate drivers), a portion of an AC power isolation system, or may form a portion of another type of system in which galvanic isolation between first and second circuits is desired.

The various components of inductive communication device 130 are packaged in a single package (e.g., an air-cavity package or overmolded package), in an embodiment. These components include a first integrated circuit (IC) die 140, a second IC die 150, and one or more dielectric components (including dielectric structure 160) positioned between the first and second IC die 140, 150. As used herein, a "dielectric component" may be an air gap or a physical structure that includes dielectric material (e.g., a layer of dielectric material or another type of structure that includes dielectric material). As will be better illustrated in the Figures that follow, the first and second IC die 140, 150 are physically arranged with respect to each other to provide inductive communication between the first and second IC die 140, 150 across a gap 170, which includes the dielectric structure 160. In some embodiments, the dielectric structure 160 may substantially fill the gap 170 between the surfaces of the first and second IC die 140, 150. In other embodiments, one or more air gaps may be present within the gap 170 (i.e., the gap 170 may not be completely filled by the dielectric structure 160).

In the embodiment depicted in FIG. 1, the inductive communication device 130 supports bi-directional communication between the circuits 110, 120. More specifically, along a, forward communication path between the first circuit 110 and the second circuit 120, the inductive communication device 130 includes first transmitter circuitry 142 and a first (primary) coil 144 within the first IC die 140, and a second (secondary) coil 154 and first receiver circuitry 152 within the second IC die 150. Along a reverse communication path between the second circuit 120 and the first circuit 110, the inductive communication device 130 includes second transmitter circuitry 156 and a third (primary) coil 158 within the second IC die 150, and a fourth (secondary) coil 148 and second receiver circuitry 146 within the first IC die 140. The first and second IC die 140, 150 also may include tuning capacitors (not illustrated) configured to enhance the resonance between primary/secondary coil pairs.

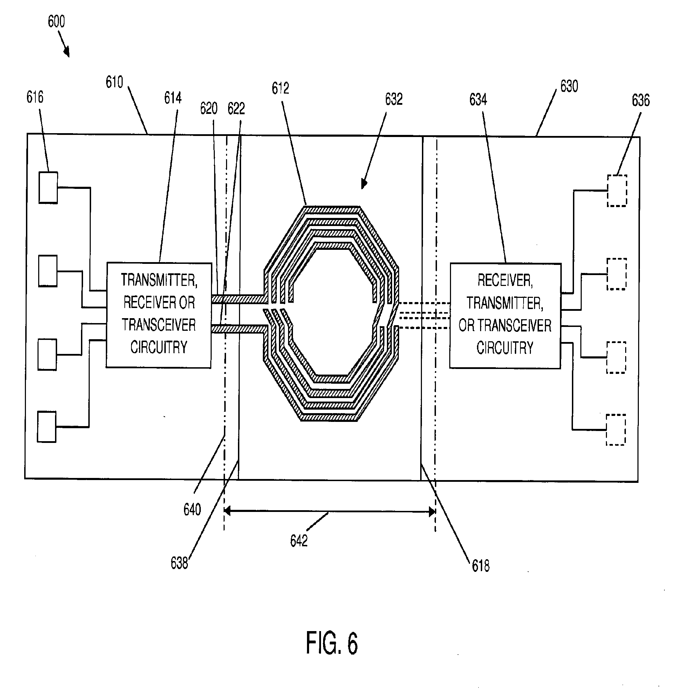

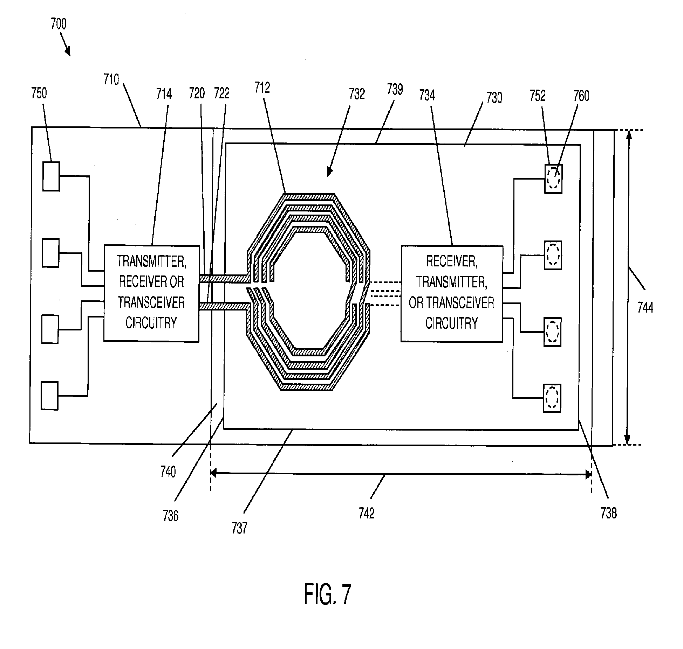

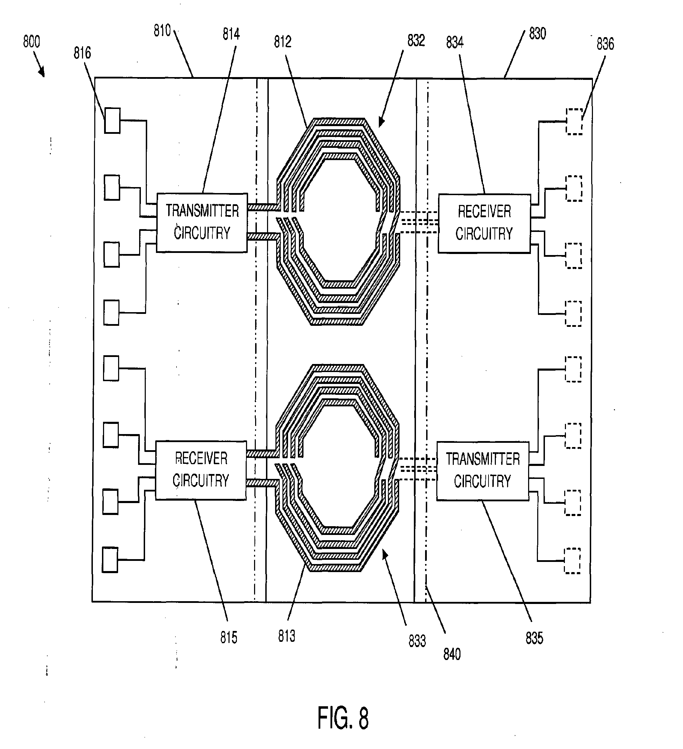

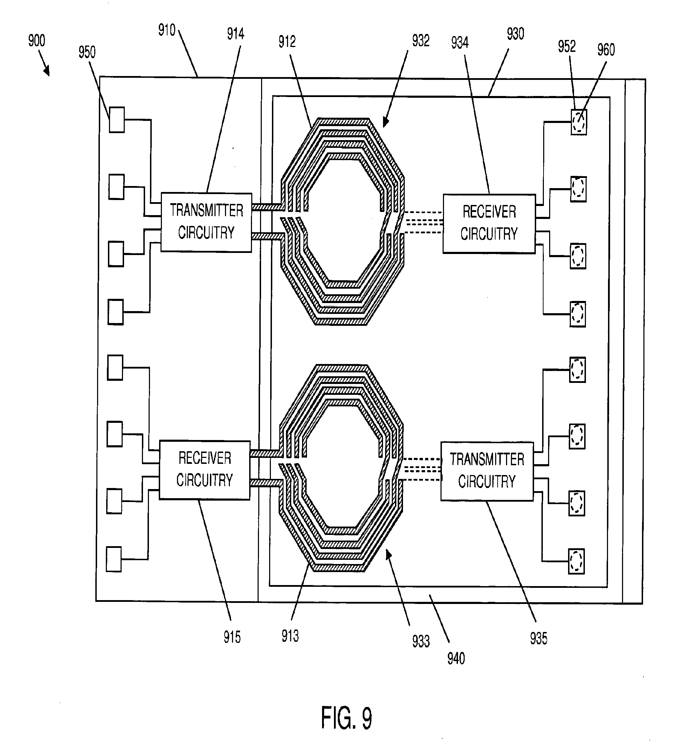

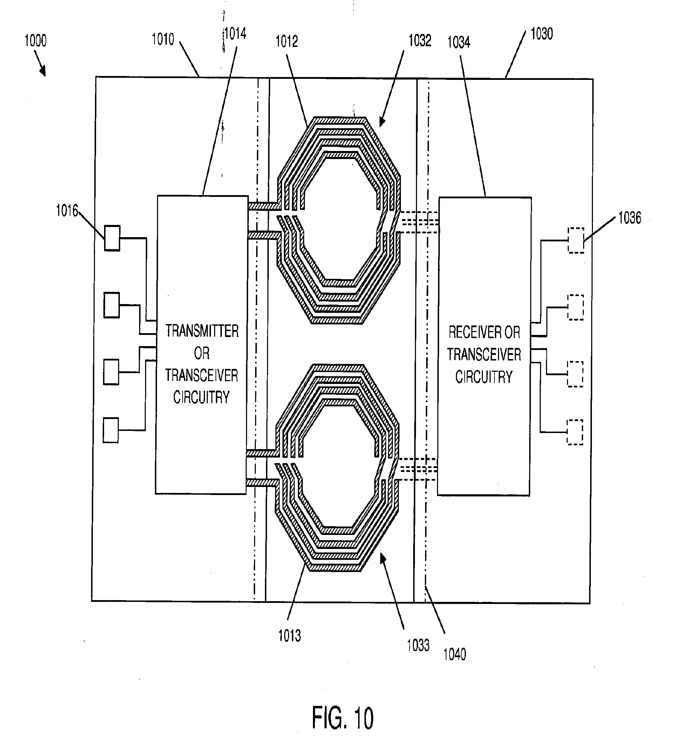

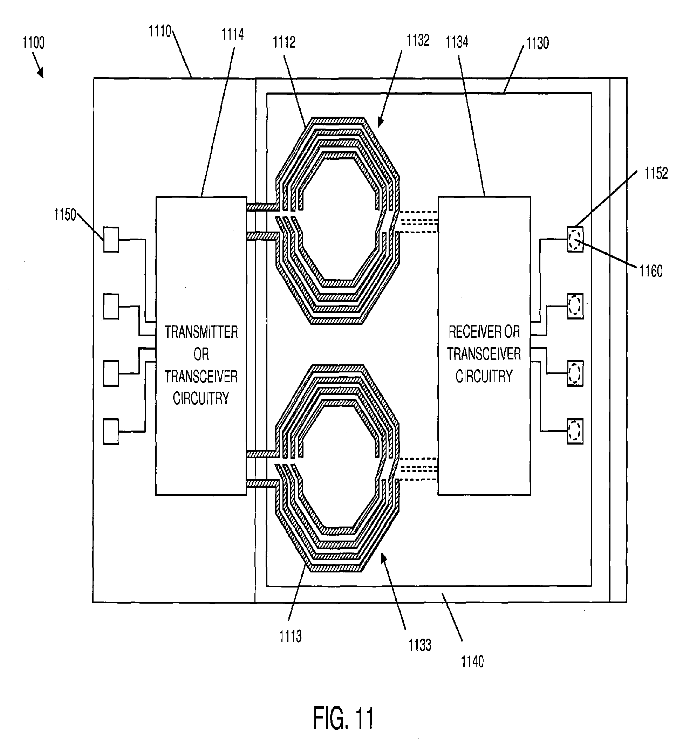

Although inductive communication device 130 is shown to provide one forward communication path and one reverse communication path (e.g., as also depicted in FIGs 8 and 9), other embodiments of inductive communication devices may provide only one communication path (i.e., only one forward or reverse communication path, such as is depicted in FIGs 6 and 7), or multiple communication paths in a particular direction (e.g., multiple forward and/or reverse communication paths, such as is depicted in FIGs 10 and 11). Alternatively, one or more of the communication paths may be bi-directional, and each IC die 140, 150 may include transceiver circuitry, rather than transmitter or receiver circuitry. In such an embodiment, communication in a forward or reverse direction may be conducted in a time-duplexed manner, and each of coils 144, 148, 154, 158 may alternate between functioning as a primary coil and a secondary coil. In addition, communication may be conducted in a full duplex manner, in which communication may be conducted simultaneously in a forward and reverse direction between a primary and a secondary coil. Although transceiver-type embodiments are not discussed extensively below, it is to be understood that such embodiments fall within the scope of the inventive subject matter.

In still other alternate embodiments, the transmitter circuitry, receiver circuitry, or transceiver circuitry may be formed on a separate IC from its associated coil. In such embodiments, the IC that includes the coil and the IC that includes the corresponding communication circuitry may both be included within a single packaged device, or may be in distinctly packaged devices.

During operation, transmitter circuitry 142, 156 receives an input signal via input nodes 132, 138, respectively. Transmitter circuitry 142, 156 then converts the input signal into a form that is appropriate for inductive communication by primary coils 144, 158, respectively. More specifically, in an embodiment, each transmitter circuitry 142, 156 provides a time-varying (e.g., oscillating) drive signal (e.g., an alternating current in the form of a sinusoidal wave, a square wave, or another wave pattern) to the primary coil 144, 158 to which it is coupled. The primary coils 148, 158 convert the drive signal into a time-varying magnetic field or flux around the primary coils 144, 158, referred to herein as the "communication signal." The time-varying magnetic field or flux generated by each primary coil 144, 158 extends across the gap 170 through the dielectric structure 160 (and other dielectric components, if they are present within the gap 170) and couples with the corresponding secondary coil 148, 154. More specifically, the communication signal is transmitted from each primary coil 144, 158 to each secondary coil 154, 148 through magnetic inductive coupling between the primary/secondary coil pairs. In response to the communication signal coupling with each secondary coil 148, 154, the secondary coil 148, 154 produces an alternating waveform or voltage, which is received by the receiver circuitry 146, 152 to which each secondary coil 148, 154 is coupled. The receiver circuitry 146, 152 then converts the signal received from the secondary coil 148, 154, respectively, into a reconstructed version of the input signal, and the reconstructed version of the input signal is provided at output nodes 134, 136, respectively, to the first and second circuitry 110, 120.

First transmitter circuitry 142 is coupled between an output of first circuit 110 and primary coil 144, and second transmitter circuitry 156 is coupled between an output of second circuit 120 and primary coil 158, in an embodiment. According to an embodiment, each transmitter circuitry 142, 156 includes an oscillator (not illustrated) and driver circuit (not illustrated) configured to provide the time-varying drive signal to the primary coil 144, 158 to which it is coupled. For example, the driver circuit may receive an input signal from first circuit 110 (e.g., an information-carrying square wave), and may convert the input signal into an alternating signal having characteristics that are conducive to inductive communication between the primary/secondary coil pairs. According to an embodiment, for example, the driver circuit may implement amplitude-shift keying (ASK) modulation to represent the digital data conveyed in an input signal. More specifically, for example, the driver circuit may implement on-off keying (OOK), in which the driver circuit produces a carrier wave at a frequency established by the oscillator when the input signal has a relatively high logic level (e.g., indicating a binary one), and refrains from producing the carrier wave when the input signal has a relatively low logic level (e.g., indicating a binary zero). In alternate embodiments, the driver circuit may implement other modulation techniques (e.g., frequency modulation, phase modulation or other techniques). According to an embodiment, the carrier wave conveyed within the drive signal may have a frequency in a band of between about 200 megahertz (MHz) and about 400 MHz (e.g., 300 MHz), although the carrier wave may have higher or lower frequencies in other bands, as well.

First receiver circuitry 152 is coupled between secondary coil 154 and an input to second circuit 120, and second receiver circuitry 146 is coupled between secondary coil 148 and an input to first circuit 110. According to an embodiment, each receiver circuitry 146, 152 includes an amplifier, a detector (not illustrated) and other circuitry configured to convert the time-varying communication signal received from the secondary coil 154, 148 to which it is coupled into a reconstructed version of the signal that was input into the corresponding transmitter circuitry 142, 156 along each communication path.

The dielectric structure 160 (and other dielectric components, if present in the gap 170) is positioned between each primary/secondary coil pair (i.e., between first and second coils 144, 154 and between third and fourth coils 148, 158). Although a single dielectric structure 160 is illustrated, distinct dielectric structures may be used, in other embodiments (e.g., one dielectric structure for each primary/secondary coil pair), or the dielectric structure 160 may be composed of distinct layers with different dielectric properties. In addition, as mentioned previously, other dielectric components may be present within the gap 170. The dielectric structure 160 (and other dielectric components, if present within the gap 170) provides DC isolation (galvanic isolation) between the first IC die 140 and the second IC die 150, and thus between the first circuit 110 and the second circuit 120. The level of DC isolation provided is affected by the combined thickness of the dielectric structure 160 and any other dielectric components within the gap 170 (or the width of the gap 170 that is established by the dielectric structure 160 and other dielectric components, if present) and the dielectric constant(s) of the dielectric structure 160 and any other dielectric components within the gap 170. For example, the dielectric structure 160 and other dielectric components, if present, may be configured to provide DC isolation in a range of about 1.0 kilovolts (kV) to about 4.0 kV, or more desirably from about 2.0 kV to about 5.0 kV, although dielectric structure 160 and other dielectric components, if present, may be configured to provide more or less DC isolation, as well.

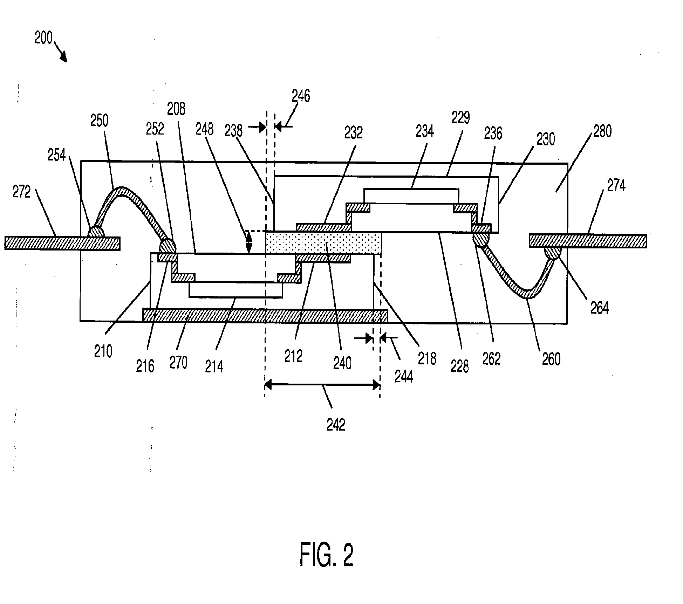

Various embodiments of an inductive communication device (e.g., device 130) and configurations of IC die and interposed dielectric structures (e.g., configurations of IC die 140, 150 and dielectric structure 160) will now be described in more detail. For example, FIG. 2 is a cross-sectional, side view of an inductive communication device 200 (e.g., inductive communication device 130, FIG. 1), according to an example embodiment. Inductive communication device 200 includes a first IC die 210, a second IC die 230, a dielectric structure 240 positioned between the first and second IC die 210, 230, a plurality of leads 272, 274, and a plurality of wirebonds 250, 260, in an embodiment. In alternate embodiments, either or both sets of wirebonds 250, 260 may be replaced by other types of electrical connections (e.g., solder bumps, stud bumps, and/or direct chip attach structures). In addition, inductive communication device 200 may include a support structure 270 and encapsulation 280. More particularly, in the embodiment depicted in FIG. 2, the electrical components of inductive communication device 200 of FIG. 2 are housed in an overmolded package (i.e., a package in which the electrical components are substantially encased in a non-conductive (e.g., plastic) encapsulant material). As mentioned previously, embodiments of inductive communication devices alternatively may include electrical components housed in an air-cavity package (i.e., a package in which the electrical components are located within an air cavity within the package, where the air cavity is typically sealed with a lid).

First IC die 210 includes at least one coil 212 (e.g., a primary coil 144, 158 or secondary coil 148, 154, FIG. 1), at least one instantiation of communication circuitry 214 (e.g., transmitter circuitry 142, 156, receiver circuitry 146, 152, FIG. 1, or transceiver circuitry), a plurality of bond pads 216, and various conductive traces and vias interconnecting the coil(s) 212, communication circuitry 214, and bond pads 216. In an alternate embodiment, as mentioned previously, the communication circuitry 214 may be included in a separate die within the same package as the die that contains the coil 212, or the communication circuitry 214 may be separately packaged. In any of the above-described embodiments, the bond pads 216 may be considered to be electrically coupled to the coil 212 (e.g., either directly or indirectly through communication circuitry 214).

Similarly, second IC die 230 includes at least one coil 232 (e.g., a primary coil 144, 158 or secondary coil 148, 154, FIG. 1), at least one instantiation of communication circuitry 234, a plurality of bond pads 236, and various conductive traces and vias interconnecting the coil(s) 232, communication circuitry 234, and bond pads 236. As was the case with the first IC die 210, in an alternate embodiment, the communication circuitry 234 may be included in a separate die within the same package as the die that contains the coil 232, or the communication circuitry 234 may be separately packaged. In whichever embodiment, the bond pads 236 may be considered to be electrically coupled to the coil 232 (e.g., either directly or indirectly through communication circuitry 234).

One of coils 212, 232 may function as a primary coil, and the other of coils 212, 232 may function as a secondary coil, or both coils 212, 232 may function as a primary and a secondary coil at alternating times (e.g., in a transceiver-type embodiment). Either way, coils 212, 232 each are proximate to a surface 208, 228 of the IC die 210, 230 in which they are included. As used herein, the term "proximate to a surface," when referring to the position of a coil means that a portion of the coil is either exposed at the surface, or that one or more non-conductive layers of material (e.g., oxide layers) is disposed over the coil, where the surface of the non-conductive layers of material establishes the surface of the IC.

In any event, the surfaces 208, 228 of the first and second IC die 210, 230 to which the coils 212, 232 are proximate are arranged to face each other within device 200 so that the coils 212, 232 are aligned with each other across a gap that is established by the dielectric structure 240. The alignment of the coils 212, 232 across the gap enables inductive communication to occur between the coils 212, 232.

Dielectric structure 240 is positioned within the gap directly between the coils 212, 232, and may extend laterally beyond the coils 212, 232. According to an embodiment, a thickness 248 of the dielectric structure 240 substantially equals the width of the gap between the coils 212, 232. Accordingly, the level of galvanic isolation between the coils 212, 232 (and thus the IC die 210, 230) is directly related to the thickness 248 of the dielectric structure 240 and the material(s) from which the dielectric structure 240 is formed. In other embodiments, other dielectric components may be present within the gap between the coils 212, 232, as well. According to an embodiment, dielectric structure 240 may have a thickness 248 in a range of about 25 micrometers (µm) to about 400 µm, or more desirably from about 100 µm to about 200 µm, although dielectric structure 240 may be thinner or thicker, as well. According to a further embodiment, the dielectric structure 240 has a width 242, which is sufficient to allow the dielectric structure 240 to extend beyond the overlapping edges 218, 238 of the first and second IC die 210, 230 by a given distance 244, 246. This extension of the dielectric structure 240 beyond the overlapping edges 218, 238 of the IC die 210, 230 may result in a reduction in fringing effects that may be present near the overlapping edges 218, 238.

Dielectric structure 240 may have a dielectric constant in a range of about 2.0 to about 5.0, although dielectric structure 240 may have a lower or higher dielectric constant, as well. According to an embodiment, dielectric structure 240 includes a material selected from polyimide, polytetrafluorethylene, benzocyclobutene, or other materials with a suitable dielectric constant. According to a particular embodiment, dielectric structure 240 has adhesive top and/or bottom sides (e.g., dielectric structure 240 may be configured as a tape made from one of the aforementioned materials). Dielectric structure 240 may be formed from a single layer of material, or dielectric structure 240 may be formed from multiple layers of a single material or multiple materials, in various embodiments.

Support structure 270 and leads 272, 274 may form portions of a leadframe, in an embodiment. In the illustrated embodiment, the support structure 270 and leads 272, 274 are not co-planar. Accordingly, the support structure 270 essentially coincides with a bottom surface of device 200, and leads 272, 274 extend from the sides of device 200 at locations that are between the bottom and top surfaces of the device 200. In alternate embodiments, the support structure 270 and leads 272, 274 may be co-planar. In such embodiments, the leads either may extend outward from the bottom of the device 200, or the leads may terminate at the sides of the device 200 (e.g., in flat no-leads types of packages).

In the embodiment illustrated in FIG. 2, the first IC die 210 is coupled to support structure 270, the dielectric structure 240 is positioned on surface 208 of the first IC die 210, and surface 228 of the second IC die 230 is coupled to a top surface of dielectric structure 240. Portions of the surfaces 208, 228 of the first and second IC die 210, 230 overlap each other to allow the coils 212, 232 to be aligned with each other. The bond pads 216 of the first IC die 210 are coupled to leads 272 extending from a first side of the device 200 via wirebonds 250. More particularly, a first end 252 of each wirebond 250 is coupled to a bond pad 216 of first IC die 210, and a second end 254 of each wirebond 250 is coupled to a lead 272. Similarly, the bond pads 236 of the second IC die 230 are coupled to leads 274 extending from a second side of the device 200 via wirebonds 260. More particularly, a first end 262 of each wirebond 260 is coupled to a bond pad 236 of second IC die 230, and a second end 264 of each wirebond 260 is coupled to a lead 274. Leads 272, 274 may correspond to an input node and an output node (e.g., one of leads 272, 274 may correspond to one of input nodes 132, 138, and the other one of leads 272, 274 may correspond to one of output nodes 134, 136, FIG. 1). Although wirebonds 250, 260 are shown to be coupled to top and bottom surfaces, respectively, of leads 272, 274, the wirebonds 250, 260 may be coupled to different surfaces from those depicted in FIG. 2, in other embodiments. Also, as mentioned previously, either or both sets of wirebonds 250, 260 may be replaced by other types of electrical connections (e.g., solder bumps, stud bumps, and/or direct chip attach structures).

The cross-sectional view illustrated in FIG. 2 depicts a single communication path between leads 272, 274. For example, the direction of the communication path may be from lead 272 to lead 274. In such a case, communication circuitry 214 of the first IC die 210 may be transmitter circuitry (e.g., transmitter circuitry 142 or 156, FIG. 1), and the coil 212 of the first IC die 210 may be a primary coil (e.g., primary coil 144 or 158, FIG. 1). Conversely, communication circuitry 234 of the second IC die 230 may be receiver circuitry (e.g., receiver circuitry 146 or 152, FIG. 1), and the coil 232 of the second IC die 230 may be a secondary coil (e.g., secondary coil 148 or 154, FIG. 1). Alternatively, the direction of the communication path may be from lead 274 to lead 272. In this case, communication circuitry 234 of the second IC die 230 may be transmitter circuitry (e.g., transmitter circuitry 142 or 156, FIG. 1), and the coil 232 of the second IC die 230 may be a primary coil (e.g., primary coil 144 or 158, FIG. 1). Conversely, communication circuitry 214 of the first IC die 210 may be receiver circuitry (e.g., receiver circuitry 146 or 152, FIG. 1), and the coil 212 of the first IC die 210 may be a secondary coil (e.g., secondary coil 148 or 154, FIG. 1). Alternatively, communication circuitry 214, 234 may be transceiver circuitry, which may function as both transmitter circuitry and receiver circuitry in a time-duplexed manner. In such an embodiment, each of coils 212,232 may alternate between functioning as a primary coil and a secondary coil. Although only a single communication path is depicted in FIG. 2, inductive communication device 200 also may include one or more additional communication paths in the same direction and/or the opposite direction as the communication path depicted in FIG. 2.

In the embodiments depicted in FIGs 2-11, various relative orientations of coils, communication circuitry, and bond pads are conveyed. More particularly, in each of the embodiments depicted in FIGs 2-11, the coils, communication circuitry, and bond pads are shown to be positioned in spatially separated portions of the respective IC die. It should be understood that, in alternate embodiments, the communication circuitry and bond pads of an IC die may be positioned in any suitable position with respect to the coil(s) of that IC die. For example, but not by way of limitation, all or portions of the communication circuitry may be placed below and/or in the center of a coil. Any suitable relative orientation of coils, communication circuitry, and bond pads is intended to be included within the scope of the inventive subject matter.

In the embodiment depicted in FIG. 2, wirebonds 260 extend between bond pads 236 on the bottom surface 228 of the second IC die 230 to the bottom surface of lead 274. For manufacturability reasons, it may be desirable to use wirebonds that extend instead between the top surface of the second IC die and the package lead. According to another embodiment, referred to herein as a "through silicon via" or "TSV" embodiment, the second IC die includes a plurality of through-silicon vias (TSVs), which enable bond pads to be provided on the top surface of the second IC die.

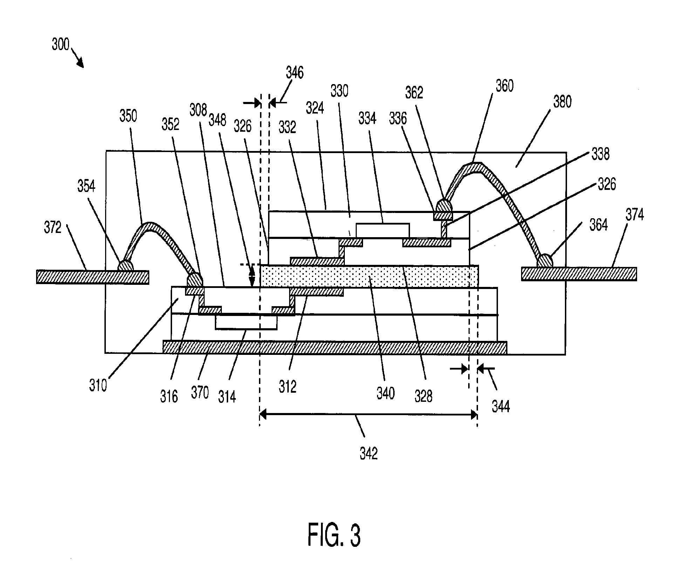

FIG. 3 is a cross-sectional, side view of an inductive communication device 300 (e.g., inductive communication device 130, FIG. 1), according to another example embodiment (a TSV embodiment). Inductive communication device 300 is similar to inductive communication device 200 (FIG. 2), except that inductive communication device 300 also includes a plurality of TSVs 338, which enable bond pads 336 to be formed on the top surface of the second IC die 330.

As with the embodiment illustrated in FIG. 2, inductive communication device 300 includes a first IC die 310, a second IC die 330, a dielectric structure 340 positioned between the first and second IC die 310, 330, a plurality of leads 372, 374, and a plurality of wirebonds 350, 360, in an embodiment. In alternate embodiments, either or both sets of wirebonds 350, 360 may be replaced by other types of electrical connections (e.g., solder bumps, stud bumps, and/or direct chip attach structures). In addition, inductive communication device 300 may include a support structure 370 and encapsulation 380. Although inductive communication device 300 is shown to be embodied as an overmolded package, it may be embodied as an air-cavity package, as well. To the extent that the various elements of inductive communication device 300 are similar to the elements of inductive communication device 200 (FIG. 2), those elements will be described only briefly, below.

First IC die 310 includes at least one coil 312 (e.g., a primary coil 144, 158 or secondary coil 148, 154, FIG. 1), at least one instantiation of communication circuitry (e.g., transmitter circuitry 142, 156, receiver circuitry 146, 152, FIG. 1, or transceiver circuitry), a plurality of bond pads 316, and various conductive traces and vias interconnecting the coil(s) 312, communication circuitry 314, and bond pads 316. In an alternate embodiment, as mentioned previously, the communication circuitry 314 may be included in a separate die within the same package as the die that contains the coil 312, or the communication circuitry 314 may be separately packaged. In any of the above-described embodiments, the bond pads 316 may be considered to be electrically coupled to the coil 312 (e.g., either directly or indirectly through communication circuitry 314).

Second IC die 330 includes at least one coil 332 (e.g., a primary coil 144, 158 or secondary coil 148, 154, FIG. 1), at least one instantiation of communication circuitry 334, a plurality of bond pads 336, a plurality of TSVs 338, and various conductive traces and vias interconnecting the coil(s) 332, communication circuitry 334, bond pads 336, and TSVs 338. As was the case with the first IC die 310, in an alternate embodiment, the communication circuitry 334 may be included in a separate die within the same package as the die that contains the coil 332, or the communication circuitry 334 may be separately packaged. In whichever embodiment, the bond pads 336 may be considered to be electrically coupled to the coil 332 (e.g., either directly or indirectly through communication circuitry 334), where at least a part of the electrical connection between the bond pads 336 and the coil 332 includes the TSVs 338.

One of coils 312, 332 may function as a primary coil, and the other of coils 312, 332 may function as a secondary coil, or both coils 312, 332 may function as a primary and a secondary coil at alternating times (e.g., in a transceiver-type embodiment). The surfaces 308, 328 of the first and second IC die 310, 330 to which the coils 312, 332 are proximate are arranged to face each other within device 300 so that the coils 312, 332 are aligned with each other across a gap that is established by the dielectric structure 340. The alignment of the coils 312, 332 across the gap enables inductive communication to occur between the coils 312, 332.

Dielectric structure 340 is positioned within the gap directly between the coils 312, 332, and may extend laterally beyond the coils 312, 332. According to an embodiment, a thickness 348 of the dielectric structure 340 substantially equals the width of the gap between the coils 312, 332. In other embodiments, other dielectric components may be present within the gap between the coils 312, 332, as well.

According to an embodiment, the first IC die 310 is wider than the second IC die 330, and the dielectric structure 340 has a width 342, which is sufficient to allow the dielectric structure 340 to extend beyond the edges 326 of the second IC die 330 by distances 344, 346. This extension of the dielectric structure 340 beyond the edges 326 of the IC die 330 may result in a reduction in fringing effects, including arcing or shorting, that may be present near the edges 326. In other embodiments, the first and second IC die 310, 330 may have substantially equal widths, or the second IC die 330 may be wider than the first IC die 310. In the latter embodiment, the dielectric structure 340 may extend beyond the edges of the first IC die 310.

Support structure 370 and leads 372, 374 may form portions of a leadframe, in an embodiment. In the illustrated embodiment, the support structure 370 and leads 372, 374 are not co-planar. In alternate embodiments, the support structure 370 and leads 372, 374 may be co-planar.

In the embodiment illustrated in FIG. 3, the first IC die 310 is coupled to support structure 370, the dielectric structure 340 is positioned on surface 308 of the first IC die 310, and surface 328 of the second IC die 330 is coupled to a top surface of dielectric structure 340. Portions of the surfaces 308, 328 of the first and second IC die 310, 330 overlap each other to allow the coils 312, 332 to be aligned with each other. The bond pads 316 of the first IC die 310 are coupled to leads 372 extending from a first side of the device 300 via wirebonds 350. More particularly, a first end 352 of each wirebond 350 is coupled to a bond pad 316 of first IC die 310, and a second end 354 of each wirebond 350 is coupled to a lead 372. Similarly, the bond pads 336 of the second IC die 330 are coupled to leads 374 extending from a second side of the device 300 via wirebonds 360. More particularly, a first end 362 of each wirebond 360 is coupled to a bond pad 336 proximate to surface 324 of second IC die 330, and a second end 364 of each wirebond 360 is coupled to a lead 374. TSVs 338 enable the bond pads 336 to be positioned on or proximate to the top surface 324 of second IC die 330 so that the wirebonds 360 may extend from the top surface 324 of the second IC die 330 to the top surface of lead 374. Leads 372, 374 may correspond to an input node and an output node (e.g., one of leads 372, 374 may correspond to one of input nodes 132, 138, and the other one of leads 372, 374 may correspond to one of output nodes 134, 136, FIG. 1).

The cross-sectional view illustrated in FIG. 3 depicts a single communication path between leads 372, 374. Although only a single communication path is depicted in FIG. 3, inductive communication device 300 also may include one or more additional communication paths in the same direction and/or the opposite direction as the communication path depicted in FIG. 3.

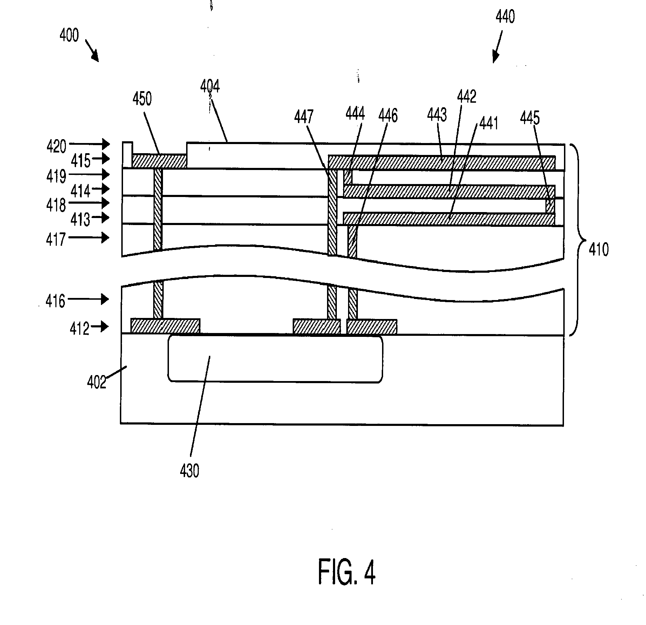

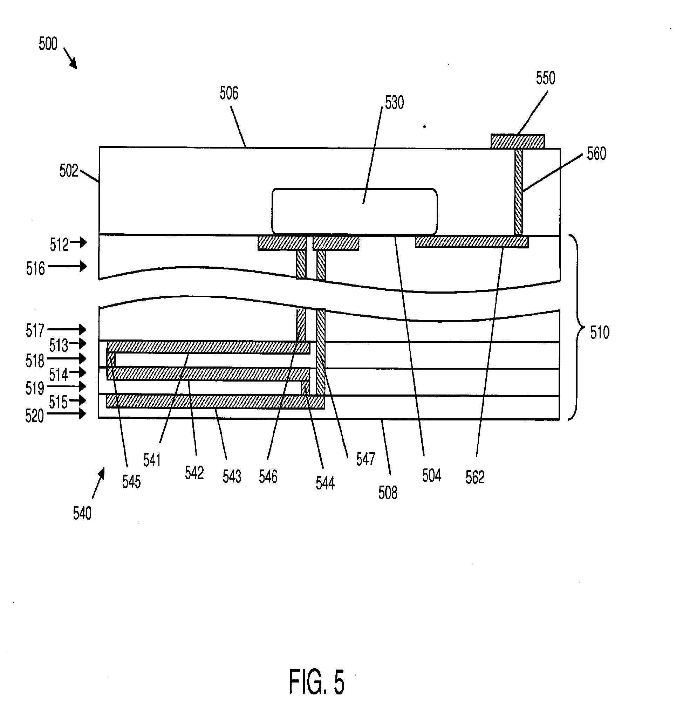

More detailed examples of embodiments of IC die (e.g., IC die 210, 230, 310, and 330) will now be described in conjunction with FIGs 4 and 5. More particularly, FIG. 4 is a cross-sectional, side view of an IC die 400 that may be used as the first or second IC die 210, 230 in the inductive communication device 200 of FIG. 2, or as the first IC die 310 in the inductive communication device 300 of FIG. 3, according to an example embodiment. IC die 400 includes a semiconductor substrate 402, and a build-up structure 410 comprising a plurality of conductive layers 412, 413, 414, 415 and dielectric layers 416, 417, 418, 419, 420 on a top surface of the semiconductor substrate 402. Various active components forming communication circuitry 430 are formed in the semiconductor substrate 402. For example, the communication circuitry 430 may be transmitter circuitry (e.g., transmitter circuitry 142 or 156, FIG. 1), receiver circuitry (e.g., receiver circuitry 146 or 152, FIG. 1) or transceiver circuitry, in various embodiments. The components of the communication circuitry 430 are interconnected through conductive traces formed in some or all of the conductive layers 412-415 and conductive vias formed between the conductive layers 412-415. At least one bond pad 450 may be formed in an uppermost conductive layer 415, and the bond pad 450 may be electrically coupled to the communication circuitry 430 through conductive vias formed through the dielectric layers 416-419 and conductive traces formed between the vias in the conductive layers 412-414. When IC die 400 is incorporated into an inductive communication device (e.g., device 130, 200, 300, FIGs 1-3), a wire bond (e.g., wirebond 250, 260, or 350, FIGs 2, 3) may be coupled between the bond pad 450 and a device lead (e.g., lead 272, 274, or 372, FIGs 2, 3). For example, bond pad 450 may correspond to a bond pad configured to receive a communication signal from external circuitry or to provide a communication signal to external circuitry (e.g., to bond pad 216, 236, or 316, FIGs 2, 3, corresponding to one of nodes 132, 134, 136, or 138, FIG. 1).

In addition, IC die 400 includes a coil 440 (e.g., one of coils 144, 148, 154, 158, 212, 232, 312, FIGs 1-3), which includes multiple substantially-concentric conductive rings 441, 442, 443 formed in one or more uppermost conductive layers 413-415 (i.e., formed proximate to the top surface 404 of IC die 400). For example, in the embodiment illustrated in FIG. 4, coil 440 includes conductive rings formed in the uppermost three conductive layers 413-415. The conductive rings in the various layers 413-415 are interconnected through conductive vias 444, 445 to form a continuous conductive coil having first and second ends that are electrically coupled to the communication circuitry 430. For example, a first end of the coil 440 may be coupled to the communication circuitry 430 through conductive via 446 and other conductive structures (not illustrated) between the coil 440 and the communication circuitry 430, and a second end of the coil 440 may be coupled to the communication circuitry 430 through conductive via 447 and still other conductive structures (not illustrated) between the coil 440 and the communication circuitry 430. In other embodiments, coil 440 may be formed using fewer or more than three conductive layers, and/or the ends of coil 440 may be located on a same conductive layer. In addition, the location of vias 444, 445 shown interconnecting the concentric conductive rings 441-443 may be located in other positions, and/or multiple vias may be used to provide a plurality of cross-overs used to construct the continuous coil 440.

The uppermost dielectric layer 420 may or may not overlie the coil 440, in various embodiments. In an embodiment in which the uppermost dielectric layer 420 does overlie the coil 440 (e.g., the embodiment illustrated in FIG. 4), the height of the portion of the uppermost dielectric layer 420 overlying the coil 440 contributes to the thickness of the gap (e.g., thickness 248, 348 of the gap, FIGs 2, 3) between the IC die 400 and a second IC die (not illustrated) that is positioned over the IC die 400. In addition, the portion of the uppermost dielectric layer 420 overlying the coil 440 may contribute to the overall level of galvanic isolation between IC 400 and the second IC, when arranged according to the embodiments discussed herein.

In accordance with the TSV embodiment depicted in FIG. 3, FIG. 5 is a cross-sectional, side view of a second IC die 500 (e.g., IC die 330, FIG. 3) that may be used in an inductive communication device (e.g., inductive communication device 130 or 300, FIGs 1, 3), according to an example embodiment. IC die 500 includes a semiconductor substrate 502, and a build-up structure 510 comprising a plurality of conductive layers 512, 513, 514, 515 and dielectric layers 516, 517, 518, 519, 520 formed over a first surface 504 of the semiconductor substrate 502. For consistency with FIG. 3 and enhanced understanding, IC die 500 is shown in the same orientation as IC die 330 of FIG. 3 (i.e., with the surface 508 of IC die 500 to which coil 540 is proximate facing downward).

Various active components forming communication circuitry 530 are formed in the semiconductor substrate 502. For example, the communication circuitry 530 may be transmitter circuitry (e.g., transmitter circuitry 142 or 156, FIG. 1), receiver circuitry (e.g., receiver circuitry 146 or 152, FIG. 1) or transceiver circuitry, in various embodiments. The components of the communication circuitry 530 are interconnected through conductive traces formed in some or all of the conductive layers 512-515 and conductive vias formed through dielectric layers between the conductive layers 512-515.

According to an embodiment, one or more bond pads 550 may be formed proximate to (e.g., on) a second surface 506 of the semiconductor substrate 502. The bond pads 550 may be electrically coupled to the communication circuitry 530 with conductive TSVs 560 extending through the semiconductor substrate 502 (e.g., extending between the surfaces 504 and 506 of the semiconductor substrate 502), along with one or more conductive traces formed in one or more of the conductive layers 512-515. When IC die 500 is incorporated into an inductive communication device (e.g., device 130, 300, FIGs 1, 3), a wire bond (e.g., wirebond 360, FIG. 3) may be coupled between the bond pad 550 and a device lead (e.g., lead 374, FIG. 3). For example, bond pad 550 may correspond to a bond pad configured to receive a communication signal from external circuitry or to provide a communication signal to external circuitry (e.g., to bond pad 336, FIG. 3, corresponding to one of nodes 132, 134, 136, or 138, FIG. 1).

In addition, IC die 500 includes a coil 540 (e.g., one of coils 144, 148, 154, 158, 332, FIGs 1, 3), which includes multiple substantially-concentric conductive rings 541, 542, 543 formed in one or more uppermost conductive layers 513-515 (i.e., formed proximate to surface 508 of IC die 500). For example, in the embodiment illustrated in FIG. 5, coil 540 includes conductive rings formed in the uppermost three conductive layers 513-515. The conductive rings in the various layers 513-515 are interconnected through conductive vias 544, 545 to form a continuous conductive coil having a first and second ends that are electrically coupled to the communication circuitry 530. For example, a first end of the coil 540 may be coupled to the communication circuitry 530 through conductive via 546 and other conductive structures (not illustrated) between the coil 540 and the communication circuitry 530, and a second end of the coil 540 may be coupled to the communication circuitry 530 through conductive via 547 and still other conductive structures (not illustrated) between the coil 540 and the communication circuitry 530. In other embodiments, coil 540 may be formed using fewer or more than three conductive layers, and/or the ends of coil 540 may be located on a same conductive layer. In addition, vias 544, 545 shown interconnecting the concentric conductive rings 541-543 may be located in other positions, and/or multiple vias may be used to provide a plurality of cross-overs used to construct the continuous coil 540.

The uppermost dielectric layer 520 may or may not overlie the coil 540, in various embodiments. In an embodiment in which the uppermost dielectric layer 520 does overlie the coil 540 (e.g., the embodiment illustrated in FIG. 5), the height of the portion of the uppermost dielectric layer 520 overlying the coil 540 contributes to the thickness of the gap (e.g., thickness 348 of the gap, FIG. 3) between the IC die 500 and another IC die (e.g., IC die 400, FIG. 4) that is positioned under the IC die 500. In addition, the portion of the uppermost dielectric layer 520 overlying the coil 540 may contribute to the overall level of galvanic isolation between IC 500 and the other IC die, when arranged according to the embodiments discussed herein.

Various embodiments of arrangements of different types of IC die within an inductive communication device will now be described in conjunction with FIGs 6-11. More particularly, FIGs 6-11 depict embodiments that include a single communication path that includes a single primary/secondary coil pair (FIGs 6, 7), multiple parallel communication paths, each of which includes a single primary/secondary coil pair (FIGs 8, 9), and a single communication path that includes multiple primary/secondary coil pairs (FIGs 10, 11).

FIG. 6 is a top view of a portion of an inductive communication device 600 with a single communication path that includes a single primary/secondary coil pair 612, 632, according to an example embodiment. More particularly, FIG. 6 illustrates the top surface of a first IC die 610, which includes a first coil 612 proximate to the top surface of the first IC die 610, first communication circuitry 614 (e.g., transmitter, receiver, or transceiver circuitry), and a plurality of first bond pads 616. Coil 612 consists of a continuous conductive structure (i.e., continuous between an input terminal 620 and an output terminal 622) that includes multiple substantially-concentric conductive rings that may be located in multiple conductive layers of the first IC die 610. In FIG. 6 (and also in FIGs 7-11), coil 612 does not appear to consist of a continuous conductive structure between input terminal 620 and output terminal 622, as there are various apparent discontinuities shown within coil 612. The discontinuities are shown to simplify the depiction of coil 612, and also to indicate that the coil's concentric rings may be coupled through conductive vias to concentric rings in underlying conductive layers, further conveying that the structure of coil 612 may be a multi-layer structure that includes a plurality of cross-overs to establish a continuous conductive structure.

Also depicted in FIG. 6 are the edges of a second IC die 630 overlying and partially overlapping the first IC die 610. The second IC die 630 includes a second coil 632 (not specifically apparent as the second coil 632 is substantially aligned with and overlies the first coil 612), second communication circuitry 634, and a second plurality of bond pads 636 (depicted using dashed lines to indicate that they are located at the bottom surface of the die 630). Some of first and second bond pads 616, 636 may be used to receive voltage supplies (e.g., power and ground), and other ones of first and second bond pads 616, 636 may be used to receive input signals, convey output signals, receive control signals, or to convey other types of signals. Although each set of first and second bond pads 616, 636 is shown to include four bond pads 616, 636, each IC 610, 630 may include more or fewer bond pads.

Also depicted in FIG. 6 are the edges of a dielectric structure 640, which is partially obscured by second IC die 630. The left and right edges of dielectric structure 640 are depicted using dashed and dotted lines to more easily differentiate the perimeter of dielectric structure 640 from the perimeters of the first and second IC die 610, 630. As discussed previously, when arranged to provide inductive communication between coils 612, 632 of the first and second IC die 610, 630, the surfaces of the first and second IC die 610, 630 to which the coils 612, 632 are proximate are oriented to face each other. In addition, the coils 612, 632 are substantially aligned with each other across a gap (e.g., gap 170, FIG. 1), which is established at least in part by the dielectric structure 640. As shown, the dielectric structure 640 is arranged so that it is present across the entire area of overlap of the coils 612, 632. In addition, in an embodiment, the dielectric structure 640 may have a width 642 such that the dielectric structure 640 extends beyond overlapping edges 618, 638 of the first and second IC die 610, 630.

The embodiment depicted in FIG. 6 provides for a single one-way or bidirectional communication path. For example, when first communication circuitry 614 includes transmitter circuitry and second communication circuitry 634 includes receiver circuitry, a one-way communication path may be established from left to right in FIG. 6, or more specifically from first bond pads 616 through transmitter circuitry 614, first coil 612, second coil 632, receiver circuitry 634, and second bond pads 636. Conversely, when first communication circuitry 614 includes receiver circuitry and second communication circuitry 634 includes transmitter circuitry, a one-way communication path may be established from right to left in FIG. 6, or more specifically from second bond pads 636 through transmitter circuitry 634, second coil 632, first coil 612, receiver circuitry 614, and first bond pads 616. When first and second communication circuitry 614, 634 each include transceiver circuitry, a time-duplexed, bi-directional communication path may be established between the first and second bond pads 616, 636.

A TSV embodiment analogous to the embodiment of FIG. 6 is depicted in FIG. 7, which is a top view of a portion of an inductive communication device 700 with a single communication path that includes a single primary/secondary coil pair 712, 732, according to an example embodiment. More particularly, FIG. 7 illustrates the top surface of a first IC die 710, which includes a first coil 712 proximate to the top surface of the first IC die 710, first communication circuitry 714 (e.g., transmitter, receiver, or transceiver circuitry), and a plurality of first bond pads 750 proximate to the top surface of the first IC die 710. Coil 712 consists of a continuous conductive structure (i.e., continuous between an input terminal 720 and an output terminal 722) that includes multiple substantially-concentric conductive rings that may be located in multiple conductive layers of the first IC die 710.

Also depicted in FIG. 7 is the top surface of a second IC die 730 overlying the first IC die 710. The second IC die 730 includes a second coil 732 (not specifically apparent as the second coil 732 is substantially aligned with and overlies the first coil 712), second communication circuitry 734, and a second plurality of bond pads 752 proximate to the top surface of the second IC die 730. TSVs 760, indicated with dashed circles, underlie and are electrically connected with the second bond pads 752, which are exposed on the top surface of the second IC die 730, according to an embodiment. Some of first and second bond pads 750, 752 may be used to receive voltage supplies (e.g., power and ground), and other ones of first and second bond pads 750, 752 may be used to receive input signals, convey output signals, receive control signals, or to convey other types of signals. Although each set of first and second bond pads 750, 752 is shown to include four bond pads 750, 752, each IC 710, 730 may include more or fewer bond pads.

Also depicted in FIG. 7 is dielectric structure 740, which is partially obscured by second IC die 730. As discussed previously, when arranged to provide inductive communication between coils 712, 732 of the first and second IC die 710, 730, the surfaces of the first and second IC die 710, 730 to which the coils 712, 732 are proximate are oriented to face each other. In addition, the coils 712, 732 are substantially aligned with each other across a gap (e.g., gap 170, FIG. 1), which is established at least in part by the dielectric structure 740. As shown, the dielectric structure 740 is arranged so that it is present across the entire area of overlap of the coils 712, 732. According to a further embodiment, the dielectric structure 740 may have dimensions 742, 744 such that the dielectric structure 740 extends beyond some or all of the edges 736, 737, 738, 739 of the second IC die 730.

The embodiment depicted in FIG. 7 provides for a single one-way or bidirectional communication path. For example, when first communication circuitry 714 includes transmitter circuitry and second communication circuitry 734 includes receiver circuitry, a one-way communication path may be established from left to right in FIG. 7, or more specifically from first bond pads 750 through transmitter circuitry 714, first coil 712, second coil 732, receiver circuitry 734, TSVs 760, and second bond pads 752. Conversely, when first communication circuitry 714 includes receiver circuitry and second communication circuitry 734 includes transmitter circuitry, a one-way communication path may be established from right to left in FIG. 7, or more specifically from second bond pads 752 through TSVs 760, transmitter circuitry 734, second coil 732, first coil 712, receiver circuitry 714, and first bond pads 750. When first and second communication circuitry 714, 734 each include transceiver circuitry, a time-duplexed, bi-directional communication path may be established between the first and second bond pads 750, 752.

FIG. 8 is a top view of a portion of an inductive communication device 800 with two communications paths, each of which includes a single primary/secondary coil pair (i.e., coil pair 812, 832 and coil pair 813, 833), according to another example embodiment. More specifically, FIG. 8 illustrates the top surface of a first IC die 810, a second IC die 830 overlying and partially overlapping the first IC die 810, and a dielectric structure 840 (depicted using dashed and dotted lines) positioned between surfaces of the first and second IC die 810, 830 to which coils 812, 813, 832, 833 are proximate.

The first IC die 810 includes first and second, spatially-separated coils 812, 813 proximate to the top surface of the first IC die 810, first transmitter circuitry 814, first receiver circuitry 815, and a plurality of first bond pads 816. The second IC die 830 includes third and fourth, spatially-separated coils 832, 833 (not specifically apparent as the third and fourth coils 832, 833 are substantially aligned with and overlie the first and second coils 812, 813, respectively), second receiver circuitry 834, second transmitter circuitry 835, and a second plurality of bond pads 836 (depicted using dashed lines to indicate that they are located at the bottom surface of the die 830). Some of first and second bond pads 816, 836 may be used to receive voltage supplies (e.g., power and ground), and other ones of first and second bond pads 816, 836 may be used to receive input signals, convey output signals, receive control signals, or to convey other types of signals. Although each set of first and second bond pads 816, 836 is shown to include eight bond pads 816, 836, each IC die 810, 830 may include more or fewer bond pads.

As with the previously described embodiments, when arranged to provide inductive communication between coils 812, 813, 832, 833 of the first and second IC die 810, 830, the surfaces of the first and second IC die 810, 830 to which the coils 812, 813, 832, 833 are proximate are oriented to face each other. In addition, the coils 812, 813, 832, 833 are substantially aligned with each other across a gap (e.g., gap 170, FIG. 1), which is established at least in part by the dielectric structure 840. As shown, the dielectric structure 840 is arranged so that it is present across the entire area of overlap of the coils 812, 813, 832, 833. In addition, in an embodiment, the dielectric structure 840 may have a width such that the dielectric structure 840 extends beyond overlapping edges of the first and second IC die 810, 830.

The embodiment depicted in FIG. 8 provides for two, one-way communication paths. More specifically, a first one-way communication path may be established from left to right in FIG. 8, or more specifically from first bond pads 816 through first transmitter circuitry 814, first coil 812, third coil 832, second receiver circuitry 834, and second bond pads 836. In addition, a second one-way communication path may be established from right to left in FIG. 8, or more specifically from second bond pads 836 through second transmitter circuitry 835, fourth coil 833, second coil 813, first receiver circuitry 815, and first bond pads 816. With the first and second communication paths being in opposite directions, the embodiment of FIG. 8 may essentially function as a transceiver.

A TSV embodiment analogous to the embodiment of FIG. 8 is depicted in FIG. 9, which is a top view of a portion of an inductive communication device 900 with two communications paths, each of which includes a single primary/secondary coil pair (i.e., coil pair 912, 932 and coil pair 913, 933), according to another example embodiment. More particularly, FIG. 9 illustrates the top surface of a first IC die 910, a second IC die 930 overlying the first IC die 910, and a dielectric structure 940 positioned between surfaces of the first and second IC die 910, 930 to which coils 912, 913, 932, 933 are proximate.

The first IC die 910 includes first and second, spatially-separated coils 912, 913 proximate to the top surface of the first IC die 910, first transmitter circuitry 914, first receiver circuitry 915, and a plurality of first bond pads 950. The second IC die 930 includes third and fourth, spatially-separated coils 932, 933 (not specifically apparent as the third and fourth coils 932, 933 are substantially aligned with and overlie the first and second coils 912, 913, respectively), second receiver circuitry 934, second transmitter circuitry 935, TSVs 960 (indicated with dashed circles), and a second plurality of bond pads 952, which are exposed on the top surface of the second IC die 930. Some of first and second bond pads 950, 952 may be used to receive voltage supplies (e.g., power and ground), and other ones of first and second bond pads 950, 952 may be used to receive input signals, convey output signals, receive control signals, or to convey other types of signals. Although each set of first and second bond pads 950, 952 is shown to include eight bond pads 950, 952, each IC die 910, 930 may include more or fewer bond pads.

As with the previously described embodiments, when arranged to provide inductive communication between coils 912, 913, 932, 933 of the first and second IC die 910, 930, the surfaces of the first and second IC die 910, 930 to which the coils 912, 913, 932, 933 are proximate are oriented to face each other. In addition, the coils 912, 913, 932, 933 are substantially aligned with each other across a gap (e.g., gap 170, FIG. 1), which is established at least in part by the dielectric structure 940. As shown, the dielectric structure 940 is arranged so that it is present across the entire area of overlap of the coils 912, 913, 932, 933. In addition, in an embodiment, the dielectric structure 940 may have dimensions such that the dielectric structure 940 extends beyond the edges of the second IC die 930.

The embodiment depicted in FIG. 9 provides for two, one-way communication paths. More specifically, a first one-way communication path may be established from left to right in FIG. 9, or more specifically from first bond pads 950 through first transmitter circuitry 914, first coil 912, third coil 932, second receiver circuitry 934, TSVs 960, and second bond pads 952. In addition, a second one-way communication path may be established from right to left in FIG. 9, or more specifically from second bond pads 952, through TSVs 960, second transmitter circuitry 935, fourth coil 933, second coil 913, first receiver circuitry 915, and first bond pads 950. With the first and second communication paths being in opposite directions, the embodiment of FIG. 9 may essentially function as a transceiver.

FIG. 10 is a top view of a portion of an inductive communication device 1000 with a single communications path, which includes two primary/secondary coil pairs (i.e., coil pair 1012, 1032 and coil pair 1013, 1033), according to yet another example embodiment. More particularly, FIG. 10 illustrates the top surface of a first IC die 1010, a second IC die 1030 overlying and partially overlapping the first IC die 1010, and a dielectric structure 1040 (depicted using dashed and dotted lines) positioned between surfaces of the first and second IC die 1010, 1030 to which coils 1012, 1013, 1032, 1033 are proximate.

The first IC die 1010 includes first and second, spatially-separated coils 1012, 1013 proximate to the top surface of the first IC die 1010, first communication circuitry 1014 (e.g., transmitter circuitry, receiver circuitry, or transceiver circuitry), and a plurality of first bond pads 1016. The second IC die 1030 includes third and fourth, spatially-separated coils 1032, 1033 (not specifically apparent as the third and fourth coils 1032, 1033 are substantially aligned with and overlie the first and second coils 1012, 1013, respectively), second communication circuitry 1034 (e.g., transmitter circuitry, receiver circuitry, or transceiver circuitry), and a second plurality of bond pads 1036 (depicted using dashed lines to indicate that they are located at the bottom surface of the die 1030). Some of first and second bond pads 1016, 1036 may be used to receive voltage supplies (e.g., power and ground), and other ones of first and second bond pads 1016, 1036 may be used to receive input signals, convey output signals, receive control signals, or to convey other types of signals. Although each set of first and second bond pads 1016, 1036 is shown to include four bond pads 1016, 1036, each IC die 1010, 1030 may include more or fewer bond pads.

As with the previously described embodiments, when arranged to provide inductive communication between coils 1012, 1013, 1032, 1033 of the first and second IC die 1010, 1030, the surfaces of the first and second IC die 1010, 1030 to which the coils 1012, 1013, 1032, 1033 are proximate are oriented to face each other. In addition, the coils 1012, 1013, 1032, 1033 are substantially aligned with each other across a gap (e.g., gap 170, FIG. 1), which is established at least in part by the dielectric structure 1040. As shown, the dielectric structure 1040 is arranged so that it is present across the entire area of overlap of the coils 1012, 1013, 1032, 1033. In addition, in an embodiment, the dielectric structure 1040 may have a width such that the dielectric structure 1040 extends beyond overlapping edges of the first and second IC die 1010, 1030.

The embodiment depicted in FIG. 10 provides for a single one-way or bidirectional communication path, where the communication signal is divided by the transmitter circuitry and provided to two primary coils in parallel. Two corresponding secondary coils receive the communication signal and provide it to receiver circuitry, which proceeds to recombine and further process the signals. For example, when first communication circuitry 1014 includes transmitter circuitry and second communication circuitry 1034 includes receiver circuitry, a one-way communication path may be established from left to right in FIG. 10, or more specifically from first bond pads 1016 through transmitter circuitry 1014, in parallel through first and second (primary) coils 1012, 1013, again in parallel through third and fourth (secondary) coils 1032, 1033, receiver circuitry 1034, and second bond pads 1036. Conversely, when first communication circuitry 1014 includes receiver circuitry and second communication circuitry 1034 includes transmitter circuitry, a one-way communication path may be established from right to left in FIG. 10, or more specifically from second bond pads 1036 through transmitter circuitry 1034, in parallel through third and fourth (primary) coils 1032, 1033, in parallel through first and second (secondary) coils 1012, 1013, receiver circuitry 1014, and first bond pads 1016. When first and second communication circuitry 1014, 1034 each include transceiver circuitry, a time-duplexed, bi-directional communication path may be established between the first and second bond pads 1016, 1036, where the communication signal is split along the path and inductively communicated through the two primary/secondary coil pairs in parallel.

A TSV embodiment analogous to the embodiment of FIG. 10 is depicted in FIG. 11, which is a top view of a portion of an inductive communication device 1100 with a single communications path, which includes two primary/secondary coil pairs (i.e., coil pair 1112, 1132 and coil pair 1113, 1133), according to yet another example embodiment. More particularly, FIG. 11 illustrates the top surface of a first IC die 1110, a second IC die 1130 overlying the first IC die 1110, and a dielectric structure 1140 positioned between surfaces of the first and second IC die 1110, 1130 to which coils 1112, 1113, 1132, 1133 are proximate.

The first IC die 1110 includes first and second, spatially-separated coils 1112, 1113 proximate to the top surface of the first IC die 1110, first communication circuitry 1114 (e.g., transmitter circuitry, receiver circuitry, or transceiver circuitry), and a plurality of first bond pads 1150. The second IC die 1130 includes third and fourth, spatially-separated coils 1132, 1133 (not specifically apparent as the third and fourth coils 1132, 1133 are substantially aligned with and overlie the first and second coils 1112, 1113, respectively), second communication circuitry 1134 (e.g., transmitter circuitry, receiver circuitry, or transceiver circuitry), TSVs 1160 (indicated with dashed circles), and a second plurality of bond pads 1152, which are exposed on the top surface of the second IC die 1130. Some of first and second bond pads 1150, 1152 may be used to receive voltage supplies (e.g., power and ground), and other ones of first and second bond pads 1150, 1152 may be used to receive input signals, convey output signals, receive control signals, or to convey other types of signals. Although each set of first and second bond pads 1150, 1152 is shown to include four bond pads 1150, 1152, each IC die 1110, 1130 may include more or fewer bond pads.

As with the previously described embodiments, when arranged to provide inductive communication between coils 1112, 1113, 1132, 1133 of the first and second IC die 1110, 1130, the surfaces of the first and second IC die 1110, 1130 to which the coils 1112, 1113, 1132, 1133 are proximate are oriented to face each other. In addition, the coils 1112, 1113, 1132, 1133 are substantially aligned with each other across a gap (e.g., gap 170, FIG. 1), which is established at least in part by the dielectric structure 1140. As shown, the dielectric structure 1140 is arranged so that it is present across the entire area of overlap of the coils 1112, 1113, 1132, 1133. In addition, in an embodiment, the dielectric structure 1140 may have dimensions such that the dielectric structure 1140 extends beyond the edges of the second IC die 1130.

The embodiment depicted in FIG. 11 provides for a single one-way or bidirectional communication path, where the communication signal is divided by the transmitter circuitry and provided to two primary coils in parallel. Two corresponding secondary coils receive the communication signal and provide it to receiver circuitry, which proceeds to recombine and further process the signals. For example, when first communication circuitry 1114 includes transmitter circuitry and second communication circuitry 1134 includes receiver circuitry, a one-way communication path may be established from left to right in FIG. 11, or more specifically from first bond pads 1150 through transmitter circuitry 1114, in parallel through first and second (primary) coils 1112, 1113, again in parallel through third and fourth (secondary) coils 1132, 1133, receiver circuitry 1134, TSVs 1160, and second bond pads 1152. Conversely, when first communication circuitry 1114 includes receiver circuitry and second communication circuitry 1134 includes transmitter circuitry, a one-way communication path may be established from right to left in FIG. 11, or more specifically from second bond pads 1152 through TSVs 1160, transmitter circuitry 1134, in parallel through third and fourth (primary) coils 1132, 1133, in parallel through first and second (secondary) coils 1112, 1113, receiver circuitry 1114, and first bond pads 1150. When first and second communication circuitry 1114, 1134 each include transceiver circuitry, a time-duplexed, bi-directional communication path may be established between the first and second bond pads 1150, 1152, where the communication signal is split along the path and inductively communicated through the two primary/secondary coil pairs in parallel.

Each of the example embodiments illustrated in FIGs 6-11 depict one or two communication paths, where each communication path provides for inductive communication using one or two primary/secondary coil pairs. Other embodiments may include multiple one-way communication paths in a particular direction (e.g., one IC die may include multiple instantiations of transmitter circuitry and corresponding primary coils and the other IC die may include the same number of instantiations of secondary coils and corresponding receiver circuitry). Still other embodiments may include multiple one-way communication paths in both directions (e.g., each IC die may include multiple instantiations of both transmitter and receiver circuitry and corresponding primary and secondary coils). Still other embodiments may include multiple bi-directional communication paths (e.g., each IC die may include multiple instantiations of transceiver circuitry and corresponding primary and secondary coils). Such embodiments are encompassed by the scope of the inventive subject matter.

In addition, in FIGs 6-11, each coil is depicted as four concentric, hexagonal conductive rings. In other embodiments, the conductive rings comprising a coil may have different shapes, and/or different numbers of concentric rings. In addition, as discussed previously, each coil may be formed using concentric rings within multiple conductive layers (e.g., as depicted in FIGs 4 and 5). In other embodiments, each coil may be formed using concentric rings within a different number of conductive layers from the embodiments depicted in FIGs 2-11.

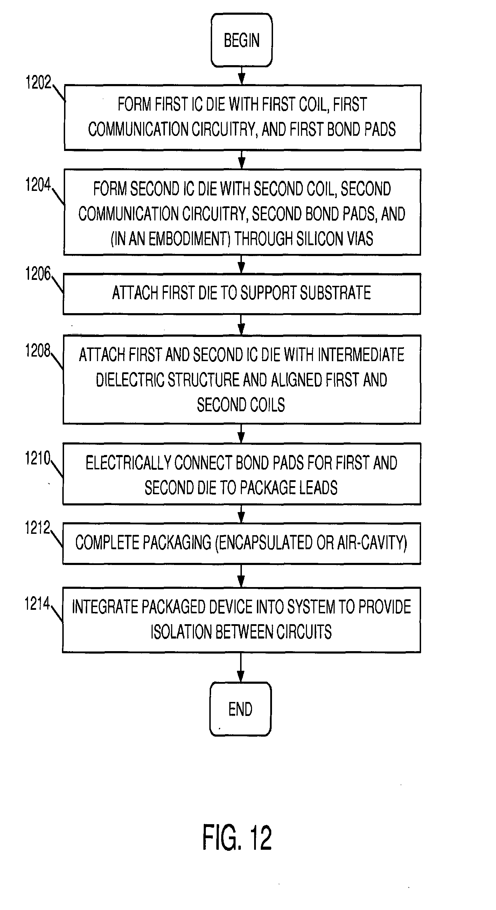

FIG. 12 is a flowchart of a method for manufacturing IC die (e.g., IC die 210, 230,310, 330, 400, 500,) and corresponding inductive communication devices (e.g., device 200, 300, FIGs 2, 3), according to an example embodiment. The method may begin, in blocks 1202 and 1204, by forming first and second IC die (e.g., IC die 210, 230, 310, 330, 400, 500) for inclusion in the inductive communication device. For example, formation of the first and second IC die in the non-TSV embodiments (e.g., the embodiment depicted in FIG. 2), or the first IC die in the TSV embodiments (e.g., the embodiment depicted in FIG. 3) may include forming various components associated with one or more instantiations of transmitter, receiver, and/or transceiver circuitry within an integrated circuit substrate (e.g., substrate 402, FIG. 4). In addition, a build-up structure (e.g., structure 410, FIG. 4) may be formed on a top surface of the semiconductor substrate, where the build-up structure includes a plurality of patterned conductive layers (e.g., layers 412, 413, 414, 415) and dielectric layers (e.g., layers 416, 417, 418, 419, 420, FIG. 4). During formation of the build-up structure, the plurality of conductive layers may be patterned to form conductive traces, and conductive vias may be formed through the dielectric layers between conductive layers to provide for electrical communication between the layers. In addition, during formation of the build-up structure, one or more coils (e.g., coil 440, FIG. 4), each of which includes multiple substantially-concentric conductive rings may be formed using one or more of the uppermost conductive layers of the build-up structure (e.g., using layers 413-415, FIG. 4). A plurality of bond pads (e.g., bond pad 450, FIG. 4) may be formed in an uppermost conductive layer to provide for electrical connectivity with the communication circuitry.

In a TSV embodiment (e.g., the embodiment depicted in FIG. 3), formation of the second IC die (e.g., second IC die 330, FIG. 3) may include forming various components associated with one or more instantiations of transmitter, receiver, and/or transceiver circuitry within an integrated circuit substrate (e.g., substrate 502, FIG. 5). According to an embodiment, a plurality of TSVs (e.g., TSVs 338, 560, FIGs 3, 5) are formed through the integrated circuit substrate, and a plurality of bond pads (e.g., bond pads 336, 550, FIGs 3, 5) are formed on or proximate to a surface of the integrated circuit substrate that is opposite a surface over which a build-up structure will be formed. The bond pads are formed so that they are electrically coupled to the TSVs. The build-up structure (e.g., structure 510, FIG. 5) may be formed on the surface of the semiconductor substrate that is opposite the bond pads. The build-up structure includes a plurality of patterned conductive layers (e.g., layers 512, 513, 514, 515, FIG. 5) and dielectric layers (e.g., layers 516, 517, 518, 519, 520, FIG. 5). During formation of the build-up structure, the plurality of conductive layers may be patterned to form conductive traces, and conductive vias may be formed through the dielectric layers between conductive layers to provide for electrical communication between the layers. In addition, during formation of the build-up structure, one or more coils (e.g., coils 332, 540, FIGs 3, 5), each of which includes multiple substantially-concentric conductive rings may be formed using one or more of the uppermost conductive layers of the build-up structure (e.g., using layers 513-515, FIG. 5).

According to an embodiment, in block 1206, the first IC die may be attached (e.g., using die attach material) to a support substrate (e.g., support substrate 270, 370, FIGs 2, 3). For example, the support substrate may form a portion of a leadframe that also includes a plurality of leads (e.g., leads 272, 274, 372, 374, FIGs 2, 3).

In block 1208, a dielectric structure (e.g., dielectric structure 240, 340, FIGs 2, 3) may be placed on or affixed to the first IC die so that the dielectric structure substantially covers the portion of the top surface of the first IC die corresponding to the coil(s). The second IC die may then be oriented so that the surface to which its coil(s) are proximate faces the dielectric structure. The coils of the first and second IC die may then be aligned, and the second IC die may be placed on or affixed to the dielectric structure (e.g., essentially resulting in one of the assemblies of FIGs 6-11).

In alternate embodiments, the sub-assembly resulting from the performance of blocks 1206 and 1208 may be formed differently. For example, while a plurality of first IC die are still in wafer form, a plurality of dielectric structures and second IC die may be aligned with and attached to the plurality of first IC die. The first IC die then may be singlulated from the wafer, and each first IC die (with attached dielectric structure and second IC die) may then be attached to the support structure. The sub-assembly could be similarly formed while a plurality of second IC die are still in wafer form. Other embodiments of fabrication sequences also may be employed to form the sub-assembly, as well.

In block 1210, the bond pads of the first and second IC die may then be electrically coupled to the package leads (e.g., by connecting wirebonds 250, 260 or other types of electrical connections between bond pads 216, 236 and leads 272, 274, FIG. 2 or by connecting wirebonds 350, 360 or other types of electrical connections between bond pads 316, 336 and leads 372, 374, FIG. 3). In alternate embodiments, for manufacturability reasons, the wirebonds (e.g., wirebonds 260, FIG. 2) that couple to the second IC die may be attached to the die pads of the second IC die prior to assembly step 1208, and those wirebonds subsequently may be attached to the leads (e.g., lead 274, FIG. 2) after assembly step 1208.

In block 1212, packaging of the inductive communication device may then be completed. For example, when the inductive communication device is housed within an overmolded package, a mold may be oriented around the leadframe, and non-conductive encapsulant (e.g., plastic encapsulant) may be dispensed into the mold and cured. Conversely, when the inductive communication device is housed within an air-cavity package, a cap may be attached over the top of the device to establish an air cavity within which the first and second IC are positioned.

In block 1214, the packaged inductive communication device may then be integrated into a system in which galvanic isolation between circuits is desired (e.g., system 100, FIG. 1). For example, as discussed previously, embodiments of inductive communication devices described herein may be incorporated into a battery charging system for an HEV, a portion of an AC power isolation system, an isolated gate driver, or other types of system in which galvanic isolation between first and second circuits is desired.

It should be understood that the various method steps illustrated in FIG. 12 may be performed in orders other than the example order illustrated, and/or the method may include more, fewer, or different steps. In addition, certain steps may be collapsed into a single step, and other single steps may be expanded into multiple steps. In addition, certain ones of the method steps may be performed in parallel, rather than serially. Those of skill in the art would understand how to modify the illustrated flowchart in manners that produce substantially the same result. Accordingly, such modifications are intended to be included within the scope of the inventive subject matter.

An embodiment of a device includes a first IC die, a second IC die, and one or more dielectric components. The first IC die has a first coil proximate to a first surface of the first IC die. The second IC die has a second coil proximate to a first surface of the second IC die. The first IC die and the second IC die are arranged within the device so that the first surface of the first IC die faces the first surface of the second IC die, and the first coil and the second coil are aligned with each other across a gap between the first IC die and the second IC die. The first IC die and the second IC die are galvanically isolated from each other. The one or more dielectric components are positioned within the gap directly between the first coil and the second coil.

An embodiment of a method for inductive communication includes providing a first signal to a first coil of a first IC die, where the first coil is proximate to a first surface of the first IC die, and the first coil converts the first signal into a time-varying magnetic field around the first coil. The method further includes receiving a second signal by a second coil of a second IC die as a result of the time-varying magnetic field coupling to the second coil. The second coil is proximate to a first surface of the second IC die, and the first IC die and the second IC die are arranged within an integrated circuit package so that the first surface of the first IC die faces the first surface of the second IC die, and the first coil and the second coil are aligned with each other across a gap between the first IC die and the second IC die so that the first IC die and the second IC die are galvanically isolated from each other.

An embodiment of a method of manufacturing an inductive communication device includes coupling together a first IC die, a dielectric structure, and a second IC die. The first IC die has a first coil proximate to a first surface of the first IC die, and the second IC die has a second coil proximate to a first surface of the second IC die. The first IC die and the second IC die are oriented so that the first surface of the first IC die faces the first surface of the second IC die, and the first coil and the second coil are aligned with each other across a gap between the first IC die and the second IC die. The dielectric structure is positioned within the gap directly between the first coil and the second coil. The method further includes electrically connecting a plurality of first bond pads of the first IC die to first package leads, and electrically connecting a plurality of second bond pads of the second IC die to second package leads.

While the principles of the inventive subject matter have been described above in connection with specific systems, apparatus, and methods, it is to be clearly understood that this description is made only by way of example and not as a limitation on the scope of the inventive subject matter. The various functions or processing blocks discussed herein and illustrated in the Figures may be implemented in hardware, firmware, software or any combination thereof. Further, the phraseology or terminology employed herein is for the purpose of description and not of limitation.

For simplicity and clarity of illustration, the drawing figures illustrate the general manner of construction, and descriptions and details of well-known features and techniques may be omitted to avoid unnecessarily obscuring the description of the embodiments. Additionally, elements in the drawings figures are not necessarily drawn to scale. For example, the dimensions of some of the elements or regions in some of the figures may be exaggerated relative to other elements or regions of the same or other figures to help improve understanding of the various embodiments.

The terms "first," "second," "third," "fourth" and the like in the description and the claims, if any, may be used for distinguishing between similar elements and not necessarily for describing a particular sequential or chronological order. It is to be understood that the terms so used are interchangeable under appropriate circumstances such that the embodiments described herein are, for example, capable of use in sequences other than those illustrated or otherwise described herein. Furthermore, the terms "comprise," "include," "have" and any variations thereof, are intended to cover non-exclusive inclusions, such that a process, method, article, or apparatus that comprises a list of elements is not necessarily limited to those elements, but may include other elements not expressly listed or inherent to such process, method, article, or apparatus. The terms "left," right," "in," "out," "front," "back," "up," "down, "top," "bottom," "over," "under," "above," "below" and the like in the description and the claims, if any, are used for describing relative positions and not necessarily for describing permanent positions in space. It is to be understood that the embodiments described herein may be used, for example, in other orientations than those illustrated or otherwise described herein. The term "coupled," as used herein, is defined as directly or indirectly connected in an electrical or non-electrical manner.

The foregoing description of specific embodiments reveals the general nature of the inventive subject matter sufficiently that others can, by applying current knowledge, readily modify and/or adapt it for various applications without departing from the general concept. Therefore, such adaptations and modifications are within the meaning and range of equivalents of the disclosed embodiments. The inventive subject matter embraces all such alternatives, modifications, equivalents, and variations as fall within the spirit and broad scope of the appended claims.

## Claims

1. A device (130, 200, 300, 600, 700, 800, 900, 1000, 1100), comprising:
a first integrated circuit (IC) die (140, 210, 310, 400, 610, 710, 810, 910, 1010, 1110) having a first coil (144, 212, 312, 440, 612, 712, 812, 912, 1012, 1112) proximate to a first surface (208, 308, 404) of the first IC die;
a second IC die (150, 230, 330, 500, 630, 730, 830, 930, 1030, 1130) having a second coil (154, 232, 332, 540, 632, 732, 832, 932, 1032, 1132) proximate to a first surface (228, 328, 508) of the second IC die, wherein the first IC die and the second IC die are arranged within the device so that the first surface of the first IC die faces the first surface of the second IC die, and the first coil and the second coil are aligned with each other across a gap (170) between the first IC die and the second IC die, and wherein the first IC die and the second IC die are galvanically isolated from each other; and
one or more dielectric components (160, 240, 340, 640, 740, 840, 940, 1040, 1140) within the gap, which are positioned directly between the first coil and the second coil.

2. The device of claim 1, wherein:
the first IC die further includes a plurality of first bond pads (216, 450, 616, 816, 1016) exposed at the first surface of the first IC die, wherein the plurality of first bond pads are electrically coupled to the first coil; and
the second IC die further includes a plurality of second bond pads (236, 550, 636, 836, 1036) exposed at the first surface of the second IC die, wherein the plurality of second bond pads are electrically coupled to the second coil.

3. The device of any one of the preceding claims, wherein:
the first IC die further includes a plurality of first bond pads (316, 450, 750, 950, 1150) exposed at the first surface of the first IC die, wherein the plurality of first bond pads are electrically coupled to the first coil; and
the second IC die further includes a semiconductor substrate (502), a plurality of conductive through-silicon vias (338, 560, 760, 960, 1160) extending through the semiconductor substrate, and a plurality of second bond pads (336, 550, 752, 952, 1152) electrically coupled to the plurality of through-silicon vias and exposed at a second surface (324, 506) of the IC die that is opposite the first surface (508) of the second IC die.

4. The device of any one of the preceding claims, wherein:
the first IC die further includes a plurality of first bond pads (216, 316, 450, 616, 750, 816, 950, 1016, 1150) that are electrically coupled to the first coil; and
the second IC die further includes a plurality of second bond pads (236, 336, 550, 636, 752, 836, 952, 1036, 1152) that are electrically coupled to the second coil, and wherein the device further comprises
first electrical connections (250, 350) coupled to the first bond pads; and
second electrical connections (260, 360) coupled to the second bond pads, and
wherein the first electrical connections and the second electrical connections are selected from wirebonds (250, 260, 350, 360), solder bumps, stud bumps, and direct chip attach structures.

5. The device of claim 4, further comprising:
a plurality of package leads (272, 274, 372, 374), wherein the first electrical connections are coupled between the first bond pads and a first set of the package leads, and the second electrical connections are coupled between the second bond pads and a second set of the package leads.

6. The device of any one of the preceding claims, wherein:
the first coil is formed from a plurality of first patterned conductors (441, 442, 443) in a plurality of first metal layers (413, 414, 415) that are separated by one or more first dielectric layers (418, 419); and
the second coil is formed from a plurality of second patterned conductors (541, 542, 543) in a plurality of second metal layers (513, 514, 515) that are separated by one or more second dielectric layers (518, 519).

7. The device of any one of the preceding claims, wherein:
the first IC die further includes transmitter circuitry (142, 214, 314, 430, 614, 714, 814, 914, 1014, 1114) coupled to the first coil; and
the second IC die further includes receiver circuitry (152, 234, 334, 530, 634, 734, 834, 934, 1034, 1134) coupled to the second coil.

8. The device of any one of the preceding claims, wherein the one or more dielectric components include one or more of: a material selected from polyimide, polytetrafluorethylene, and benzocyclobutene; a portion of a dielectric layer (420) overlying the first coil; a portion of a dielectric layer (520) overlying the second coil; and an air gap.

9. The device of any one of the preceding claims, wherein:
the first IC die further includes one or more additional first coils (148, 813, 932, 1032, 1132) proximate to the first surface of the first IC die;
the second IC die further includes one or more additional second coils (158, 833, 933, 1033, 1133) proximate to the first surface of the second IC die, wherein each of the additional first coils is aligned with a corresponding one of the additional second coils across the gap; and
the one or more dielectric components are positioned within the gap directly between aligned pairs of the additional first coils and the additional second coils.

10. The device of any one of the preceding claims, wherein the first IC die, the second IC die, and the one or more dielectric components are packaged together in an air-cavity package.

11. The device of any one of the preceding claims, wherein the first IC die, the second IC die, and the one or more dielectric components are packaged together in an overmolded package.

12. An inductive communication method, comprising the steps of:
providing a first signal to a first coil (144, 212, 312, 440, 612, 712, 812, 912, 1012, 1112) of a first integrated circuit (IC) die (140, 210, 310, 400, 610, 710, 810, 910, 1010, 1110), wherein the first coil is proximate to a first surface (208, 308, 404) of the first IC die, and the first coil converts the first signal into a time-varying magnetic field around the first coil; and
receiving a second signal by a second coil (154, 232, 332, 540, 632, 732, 832, 932, 1032, 1132) of a second IC die (150, 230, 330, 500, 630, 730, 830, 930, 1030, 1130) as a result of the time-varying magnetic field coupling with the second coil, wherein the second coil is proximate to a first surface (228, 328, 508) of the second IC die, and wherein the first IC die and the second IC die are arranged within an integrated circuit package so that the first surface of the first IC die faces the first surface of the second IC die, and the first coil and the second coil are aligned with each other across a gap (170) between the first IC die and the second IC die so that the first IC die and the second IC die are galvanically isolated from each other.

13. The method of claim 12, further comprising:
receiving an input signal at a bond pad (216, 450, 616, 750, 816, 950, 1016, 1150) of the first IC die;
converting the input signal to the first signal by transmitter circuitry (142, 214, 314, 430, 614, 714, 814, 914, 1014, 1114) of the first IC die;
receiving the second signal by receiver circuitry (152, 234, 334, 530, 634, 734, 834, 934, 1034, 1134) of the second IC die;
producing, by the receiver circuitry, a reconstructed version of the input signal from the second signal; and
providing the reconstructed version of the input signal to a second bond pad (236, 336, 550, 636, 752, 836, 952, 1036, 1152) of the second IC die.

14. A method of manufacturing an inductive communication device (130, 200, 300, 600, 700, 800, 900, 1000, 1100), the method comprising the steps of:
coupling together (1208) a first integrated circuit (IC) die (140, 210, 310, 400, 610, 710, 810, 910, 1010, 1110), a dielectric structure (160, 240, 340, 640, 740, 840, 940, 1040, 1140), and a second IC die (150, 230, 330, 500, 630, 730, 830, 930, 1030, 1130), wherein the first IC die has a first coil (144, 212, 312, 440, 612, 712, 812, 912, 1012, 1112) proximate to a first surface (208, 308, 404) of the first IC die, the second IC die (150, 230, 330, 500, 630, 730, 830, 930, 1030, 1130) has a second coil (154, 232, 332, 540, 632, 732, 832, 932, 1032, 1132) proximate to a first surface (228, 328, 508) of the second IC die, the first IC die and the second IC die are oriented so that the first surface of the first IC die faces the first surface of the second IC die, and the first coil and the second coil are aligned with each other across a gap (170) between the first IC die and the second IC die, and wherein the dielectric structure is positioned within the gap directly between the first coil and the second coil;
electrically connecting (1210) a plurality of first bond pads (216, 316, 450, 616, 750, 816, 950, 1016, 1150) of the first IC die to first package leads (272, 372); and
electrically connecting (1210) a plurality of second bond pads (236, 336, 550, 636, 752, 836, 952, 1036, 1152) of the second IC die to second package leads (274, 374).

15. The method of claim 14, wherein:
forming (1202) the first IC die further comprises forming first communication circuitry (142, 214, 314, 430, 614, 714, 814, 914, 1014, 1114) between the plurality of first bond pads and the first coil; and forming (1202) the second IC die further comprises forming second communication circuitry (152, 234, 334, 530, 634, 734, 834, 934, 1034, 1134) between the plurality of second bond pads and the second coil.
